# EUROPEAN PATENT APPLICATION

(11) **EP 4 708 139 A1**
(43) Date of publication of application: **11.03.2026**
(21) Application number: 25199573.4
(22) Date of filing: 02.09.2025
(51) Int. Cl.: G06N 3/0455, G06N 3/084, G06N 3/09, G06N 5/01

(54) **METHOD OF PREPROCESSING DATA FOR EFFICIENT MACHINE LEARNING**

(30) Priority: 10.09.2024 KR 20240123572
(71) Applicant: SAMSUNG SDI CO., LTD., Yongin-si, Gyeonggi-do 17084 (KR)
(72) Inventor: KIM, Soojin, 17084 Yongin-si (KR); LEE, Kyungmin, 17084 Yongin-si (KR); KIM, Seulwoo, 17084 Yongin-si (KR); SUH, Seungbum, 17084 Yongin-si (KR); KIM, Dongyoung, 17084 Yongin-si (KR); KIM, Hyeonsu, 17084 Yongin-si (KR)
(74) Representative: Marks & Clerk LLP

(57) **Abstract**

Provided is a method of preprocessing data for efficient machine learning. The method includes generating a feature prediction model based on a training dataset including a plurality of features of a target variable; generating, using the feature prediction model, a sub-feature list, which is a list of other features dependent on each feature constituting the training dataset; calculating correlation coefficients between the plurality of features and the target variable based on the training dataset; and selecting a feature to be used for training a model that predicts the target variable, from among the plurality of features based on the correlation coefficients and the sub-feature list.

## Description

### BACKGROUND

### 1. Field

Aspects of some embodiments of the present disclosure relate to a method of preprocessing data for identifying the relative importance of individual features for training a machine learning model and removing features that are not required for training the machine learning model based on the importance.

### 2. Description of Related Art

The application of general-purpose machine learning models has increased. In situations in which the mechanism for the learning domain is not clearly identified, training the model based only on data requires a large amount of training data. However, securing a large amount of data in which noise is removed is very difficult. And when the mechanism is not clearly identified, there are cases where features that are not required for training are included. This increases model complexity and may lead to overfitting of the trained model. To prevent such overfitting, techniques such as weight regularization, e.g. L1 regularization or L2 regularization, are applied.

On the other hand, in machine learning for developing models in which physics-based mechanisms are reflected with a relatively small amount of data, when the mechanism is clear, training may be conducted by selecting only features (variables) that ensure independence based on the theory. However, when the mechanism is not clear, the model may be trained based on data collected without verifying the interrelationship or independence of each feature. As the number of features increases, the complexity of the model increases, and thus a large amount of data may be required for successful training. Or variables that may not need to be used in the model training may be reflected in the model, which may cause overfitting.

The information disclosed in this section is for enhancement of understanding of the background of the present disclosure and it may contain information that does not constitute related (or prior) art.

### SUMMARY OF THE DISCLOSURE

The present disclosure is directed to providing a method of preprocessing data that allows the complexity of a machine learning model to be reduced by identifying whether a feature for training the machine learning model has an influence on a target value so as to determine in advance that the feature is required for training.

In some embodiments, the present disclosure is directed to providing a method of preprocessing data, in which, in order to reduce the complexity of a machine learning model and the time required for training the machine learning model, the influence of each feature of a target is identified using an autoencoder or a Lasso regression model to identify the independence of each feature for which the influence is identified, a sub-feature list, which is a list of dependent features, is generated, and training features to be applied to the training of the machine learning model are selected using correlation coefficients between each feature and a target variable and the sub-feature list to generate a training feature list. But the technical objectives of the present disclosure are not limited in this regard, and other objectives that are not described may become apparent to those of ordinary skill in the art based on the following description and the accompanying drawings.

According to an aspect of the present disclosure, there is provided a method of preprocessing data, with the method including using a data preprocessing system to: receive a training dataset including a plurality of features and a target variable; generate a feature prediction model based on the training dataset; generate a sub-feature list using the feature prediction model, which is a list of other features dependent on each feature constituting the training dataset, using the feature prediction model; calculate correlation coefficients between the plurality of features and the target variable based on the training dataset; and select a feature to be used for training a model that predicts the target variable from among the plurality of features based on the correlation coefficients and the sub-feature list.

The feature prediction model may be a machine learning model.

The feature prediction model may be an autoencoder.

The feature prediction model may be an autoencoder having the same number of input nodes and output nodes as the number of the plurality of features.

The generating of the sub-feature list may include generating the sub-feature list based on a result of perturbation analysis using the autoencoder.

The feature prediction model may be a regression model to which Lasso L1 (e.g. least absolute shrinkage and selection operator) regularization is applied.

The generating of the sub-feature list may include generating the sub-feature list based on a result of perturbation analysis using the regression model to which the Lasso L1 regularization is applied.

The selecting of the feature may include determining whether a correlation coefficient between a specific feature among the plurality of features and the target variable is greater than a predetermined threshold value; when the correlation coefficient between the specific feature and the target variable is greater than the predetermined threshold value, determining whether the correlation coefficient between the specific feature and the target variable is greater than correlation coefficients between all sub-features in a sub-feature list of the specific feature and the target variable; and when the correlation coefficient between the specific feature and the target variable is greater than the correlation coefficients between all sub-features in the sub-feature list of the specific feature and the target variable, selecting the specific feature as the feature to be used for training the model predicting the target variable.

The process of interpreting relationships by applying perturbation to autoencoder input features while observing changes in restored values is not limited to forming features and a sub-feature list and may also be utilized when the values to be restored are target variables. In this case, a correlation coefficient with the target variable is not derived but may be relatively quantified based on the maximum change value for the perturbation.

The selecting of the feature may further include, when the correlation coefficient between the specific feature and the target variable is less than or equal to a correlation coefficient between at least one sub-feature in the sub-feature list of the specific feature and the target variable, selecting a sub-feature having a maximum value among correlation coefficients between sub-features in the sub-feature list of the specific feature and the target variable as the feature to be used for training the model predicting the target variable.

The method may further include generating a feature list including the selected features when the selecting of the feature is performed for all of the plurality of features.

According to another aspect of the present disclosure, there is provided a system for preprocessing data, which is a system including at least one processor configured to execute instructions stored in at least one memory.

The at least one processor is configured to execute the instructions to cause the system to: generate a feature prediction model based on a training dataset including a plurality of features and a target variable; generate, using the feature prediction model, a sub-feature list of other features dependent on each feature constituting the training dataset; calculate correlation coefficients between the plurality of features and the target variable based on the training dataset; and select a feature to be used for training a model that predicts the target variable, from among the plurality of features based on the correlation coefficients and the sub-feature list.

The training data set may include one or more instances. The instances may include data for a plurality of features (e.g. f₁, f₂, ..., and fₙ) and data for a target variable Y.

In one embodiment, the target variable is a performance indicator of a battery (e.g. a capacity, an energy density, a stability, and a lifetime). One or more of the features may be a variable that may affect the battery performance indicator (e.g. a boiling point of an electrolyte solvent). For instance, the features may be battery performance indicator features (e.g. features of a battery, such as material characteristics of components of the battery) and the target variable may be a performance indicator of the battery (e.g. a variable specifying a performance of the battery, such as capacity, energy density, stability and/or lifetime). After training, the model may be utilized to determine parameters (e.g. optimum or improved parameters) for a battery (e.g. particular values for features of the battery that provide improved performance). Once the parameters have been determined, the system may be configured to output the parameters to a manufacturing execution system to instruct the manufacturing execution system to manufacture a battery according to the determined parameters. **In** addition or alternatively, the system may be configured to output instructions (e.g. computer executable instructions) to a manufacturing execution system to instruct the manufacturing execution system to manufacture a battery according to the determined parameters.

**In** one embodiment, the one or more features are performance parameters of a battery. The performance parameters may be from sensor data (e.g. monitoring the battery in use). The performance parameters may include one or more of temperature, current, voltage, size (e.g. amount of swelling), etc. of the battery. The target value may be indicative of battery health or risk (e.g. a battery health parameter). For instance, the target value may predict the risk that the battery might fail or might be failing. In addition or alternatively, the target value may indicate a predicted requirement to take remedial action. Remedial action may include one or more of shutting off the battery, issuing an alert, controlling an extinguisher to extinguish a fire in the battery, etc. After training, the model may be configured to interface with a battery management system (e.g. for receiving input data (e.g. including performance parameters) and/or outputting output data (e.g. target value(s))).

In one embodiment, the one or more features are manufacturing features. The manufacturing features may be from sensor data (e.g. monitoring a manufacturing process of the battery). The manufacturing features may include image features (e.g. image data from images of one or more batteries during manufacture). The target value may be indicative of manufacturing quality and/or manufacturing defect. For instance, the target value may predict the likelihood that the battery is defective. In addition or alternatively, the target value may indicate a predicted requirement to take remedial action. Remedial action may include one or more of discarding the battery from the manufacturing process, directing the battery for corrective action (e.g. correcting one or more defects), and adjusting manufacturing parameters (e.g. for later steps in the manufacturing process for the battery, or for earlier steps in the manufacturing process for other batteries). After training, the model may be configured to interface with a manufacturing execution system (e.g. for receiving input data (e.g. including manufacturing features) and/or outputting output data).

More generally, the one or more features may comprise features of sensor data (e.g. real-world sensor data). For instance, the one or more features may comprise image or video features (e.g. pixel intensities).

More generally, the target value may comprise a classification and/or a prediction of a likelihood of an event. The target value may comprise one or more commands or instructions for controlling machinery (e.g. real-world machinery).

At least some of the above and other features of the invention are set out in the claims.

Aspects and features of the present disclosure are not limited to those described above, and other aspects and features not specifically mentioned herein will be clearly understood by those skilled in the art from the description of the present disclosure below.

### BRIEF DESCRIPTION OF THE DRAWINGS

The drawings illustrate embodiments of the present disclosure and further describe aspects and features of the present disclosure together with the detailed description of the present disclosure. The present disclosure should not be construed as being limited to the drawings.
FIGS. 1 and 2 are flowcharts for describing a method of preprocessing data according to embodiments of the present disclosure;
FIGS. 3 and 4 are diagrams for describing a process of generating a sub-feature list of each feature using an autoencoder-based feature prediction model; and
FIG. 5 is a block diagram illustrating a system for preprocessing data for implementing a method according to embodiments of the present disclosure.

### DETAILED DESCRIPTION OF EMBODIMENTS

Embodiments of the present disclosure will be described, in detail, with reference to the accompanying drawings. The terms or words used in the present disclosure are not to be narrowly interpreted according to their general or dictionary meanings and should be interpreted as having meanings and concepts that are consistent with the technical idea of the present disclosure on the basis of the principle that an inventor can be his/her own lexicographer to appropriately define concepts of terms to describe his/her invention in the best way. The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

In the figures, dimensions of the various elements, layers, etc. may be exaggerated for clarity of illustration. The same reference numerals designate the same elements.

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

It should be understood that, although the terms "first," "second," etc. may be used herein to describe various elements, these elements are not limited by these terms. These terms are only used for distinguishing one element from another. For example, a first element could be called a second element without departing from the scope of the present disclosure unless specifically stated to the contrary.

As used herein, the singular forms "a" and "an" are intended to include the plural forms as well, unless the context clearly indicates otherwise.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list.

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C.

As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure.

Hereinafter, embodiments of the present disclosure will be described in detail with reference to the accompanying drawings. In order to facilitate overall understanding when describing the present disclosure, the same reference numerals are used for the same elements in the drawings.

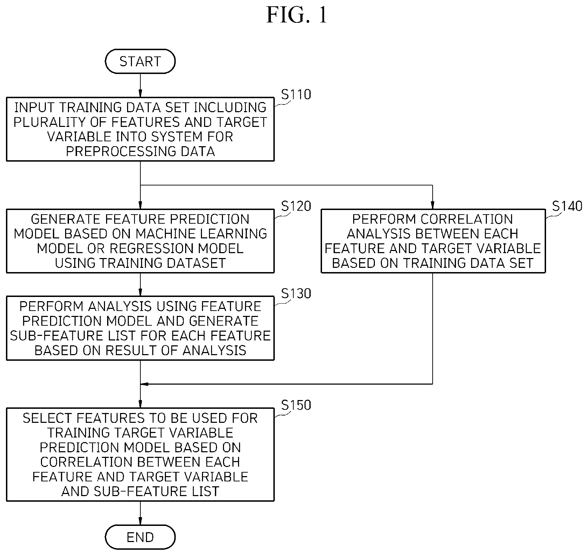

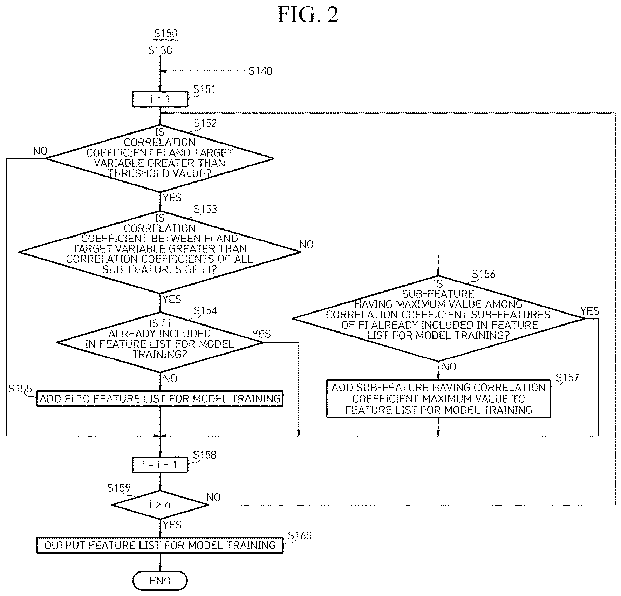

FIGS. 1 and 2 are flowcharts for describing a method of preprocessing data according to embodiments of the present disclosure.

Referring to FIG. 1, the method of preprocessing data according to embodiments of the present disclosure includes operations S110 to S150. Operation S140 may be performed in parallel with operation S120 or S130. Operation S150 is performed after operations S130 and S140 are completed.

The method of preprocessing data illustrated in FIG. 1 is based on an embodiment. But the operations of the method of preprocessing data according to the present disclosure are not limited to the embodiment illustrated in FIG. 1, and some operations may be added, changed, or deleted as needed.

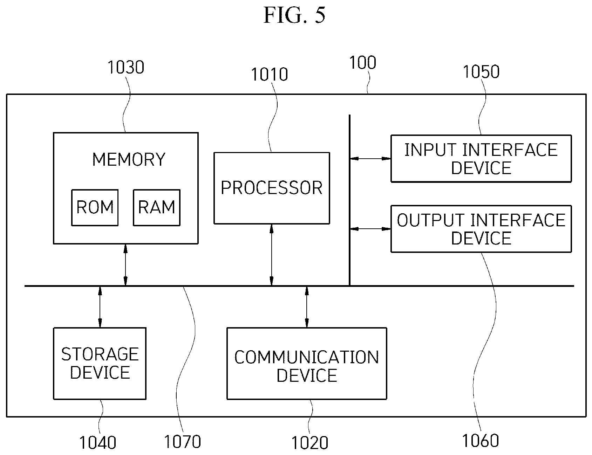

For convenience, it is assumed that the method of preprocessing data according to the embodiment of the present disclosure is performed by a system 100 (see FIG. 5) for preprocessing data. However, it will be understood that the method of preprocessing data according to embodiments of the present disclosure may be performed by another apparatus.

In operation S110 a training data set is received. In this operation, a processor 1010 included in the system 100 for preprocessing data receives a training data set including a plurality of features and a target variable from an external device or a user through a communication device 1020 or an input interface device 1050. The system 100 stores the training data set in a memory 1030 or a storage device 1040.

The training data set includes one or more instances. The instances include data for a plurality of features f₁, f₂, ..., and fₙ and data for a target variable Y. For example, the target variable may be one of the performance indicators of a battery (e.g. a capacity, an energy density, a stability, and a lifetime). One or more of the features may be a variable that may affect the battery performance indicator (e.g. a boiling point of an electrolyte solvent). For instance, the features may be battery performance indicator features (e.g. features of a battery, such as material characteristics of components of the battery) and the target variable may be a performance indicator of the battery (e.g. a variable specifying a performance of the battery, such as capacity, energy density, stability and/or lifetime). However, there is no limitation on the features or the target variable that constitute the training data set in the present disclosure.

In operation S120, a feature prediction model is generated. The processor 1010 generates the feature prediction model based on the training data set. In the present disclosure, the feature prediction model is a model that uses one or more of the received features to predict one or more other features, and the model is used to determine independence or dependence between features. The feature prediction model may be a machine learning model or a regression model such as a linear equation.

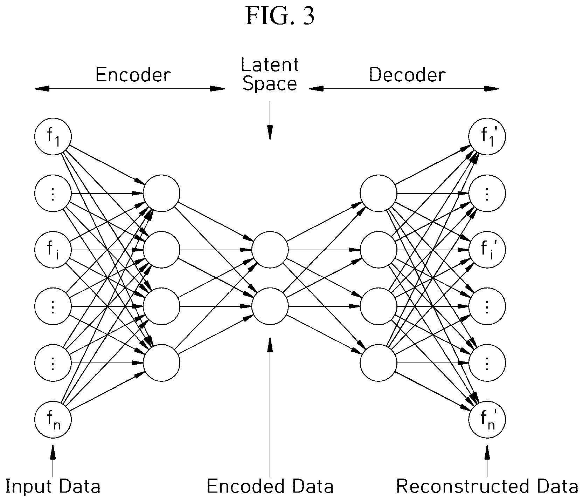

In a specific example, the feature prediction model in an autoencoder having the same number of input nodes and output nodes as the number n of the plurality of features (see FIG. 3). An autoencoder is a type of machine learning model. An autoencoder is a restoration model that rearranges and utilizes features that have the highest influence and are required for expressing itself through its own restoration process. An autoencoder is configured to encode data into a latent space (e.g. having a smaller number of features (dimensions) than the input) and decode the encoded data to generate an output (e.g. predicted features). Autoencoders are generally trained to reconstruct the input (e.g. generate an output that matches the input). An autoencoder may be trained based on an objective function that aims to minimize the error (e.g. difference) between the input and output (e.g. minimize a mean squared error). An autoencoder is suitable for use as a feature prediction model of a method of preprocessing data according to the present disclosure.

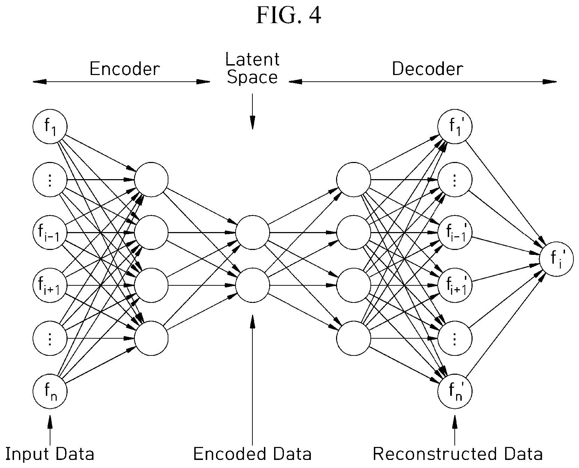

As another example, the feature prediction model may be an autoencoder that, for a specific feature, has the same number of input nodes and output nodes as the number of features n-1 excluding the specific feature among the plurality of features. In this case, a layer having only a node that predicts the specific feature is added to a decoder layer (see FIG. 4). The final layer may predict the specific feature based on the n-1 output features (e.g. predicted features). The autoencoder may be trained based on an objective function that aims to minimize the error (e.g. difference) between the n input features and the n predicted features (e.g. minimize a mean squared error). The n predicted features may comprise the n-1 predicted features in the penultimate layer of the decoder, and the predicted specific feature from the final layer of the decoder.

As still another example, the feature prediction model may be a regression model to which least absolute shrinkage and selection operator (otherwise known as "lasso", "L1" or "Lasso L1") regularization is applied. The regression model may be a model that configures a specific feature as a prediction target variable y and other features excluding the specific feature among the plurality of features that constitute the training dataset as input variables x. In this context, an "other" feature may be a feature selected from the plurality of features, but not including the specific feature. L1 regularization may add a penalty term to a loss function. The penalty term may aim to minimize the values (e.g. the magnitudes) of the weights of the regression model. As an example, the loss function may include a first term that based on error (e.g. based on a mean squared error) and a second term based on weights (e.g. based on a sum of magnitudes of the weights). The weights may be optimized to minimize the loss function.

The processor 1010 may generate a feature prediction model by training the above-described autoencoder or regression model based on the training data set.

In training the feature prediction model composed of an autoencoder or a regression model, a mean squared error (MSE) calculated by the difference between an actual value and a predicted value may be used as a loss function. In the case of an autoencoder, the processor 1010 may update the weight of each edge through backpropagation. For instance, the weights (e.g. parameters) of the model may be optimized to minimize the output of the loss function (e.g. minimize the mean squared error). The weights may be updated using gradient descent.

In operation S130, a sub-feature list is generated. In the present disclosure, a sub-feature list is a list of other features dependent on each feature constituting a training data set. In this instance, an "other" feature may be a feature selected from the plurality of features, but not including the feature to which the sub-feature list relates. A sub-feature list may be determined for each feature. For a given feature, the sub-feature may list any other features that are dependent on the feature. Therefore, when two features fₐ and f_{b} included in a plurality of features constituting a training data set are independent of each other, the two independent features are not included in the sub-feature lists for each other. That is, fₐ is not included in the sub-feature list of f_{b}, and f_{b} is not included in the sub-feature list of fₐ. Where two features are dependent on each other (e.g. are interdependent), they may be included in each other's sub-feature lists. Accordingly, for a certain feature, a sub-feature list is a list of other features from the plurality of features (e.g. features from the plurality of features excluding the certain feature) that are determined to be dependent on the certain feature.

The processor 1010 generates a sub-feature list for each feature constituting the training data set using the feature prediction model generated in operation S120. In embodiments of the present disclosure, when the feature prediction model is an autoencoder, the processor 1010 generates a sub-feature list for each feature based on a result of perturbation analysis using the autoencoder.

When performing perturbation analysis using the autoencoder shown in FIG. 3 or FIG. 4, the processor 1010 may generate a sub-feature list by applying perturbation to each of the other features f₁, ... fᵢ₋₁, fᵢ₊₁, ...and, fₙ except for a specific feature fᵢ. When the difference in a result value of a prediction node fᵢ' for the specific feature exceeds a predetermined allowable range (for example, the range of a rate of change of a prediction value for the specific feature) during decoding, the feature to which the perturbation has been applied is included in a sub-feature list of the specific feature. For instance, where the difference exceeds a threshold value, the feature to which the perturbation has been applied may be included in the sub-feature list of the specific feature.

In an embodiment of the present disclosure, the processor 1010 may generate a sub-feature list using Shapley additive explanations (SHAP) among perturbation techniques. For instance, a Shapley values can represent the relative contribution of a feature towards an output. Shapley values can be used to determine the dependence between features. A Shapley value for a given feature can be decomposed into a matrix of values (e.g. interaction values), where each entry in the matrix is an interaction value that represents the dependence (e.g. interaction) of the feature on another feature. Accordingly, Shapley values may be used to determine the relative interaction (e.g. dependence) between features. For instance, for a specific feature, any other feature that has an interaction value with the specific feature that is above a threshold value may be included in the sub-feature list for that specific feature.

When the feature prediction model is a regression model to which Lasso L1 regularization is applied, the processor 1010 performs a regression analysis between the other features f₁, ... fᵢ₋₁, fᵢ₊₁, ..., and fₙ excluding a specific feature fᵢ and the specific feature fᵢ using the regression model to obtain a weight of features that affect the specific feature fᵢ. In this case, since the weight of an independent feature that does not affect the specific feature is 0 due to the application of L1 regularization, the influence of the feature is deleted. Other features that affect the specific feature may be classified into a sub-feature list of the specific feature. For instance, other features that have a weight that is greater than a threshold or that have a non-zero weight may be classified into the sub-feature list of the specific feature.

Operation S140 is a correlation analysis operation. The processor 1010 calculates a correlation coefficient between a plurality of features and a target variable based on a training data set.

In operation S150, features are selected to be used for training a target variable prediction model and generating a feature list based on the selection result. In this operation, the processor 1010 selects a feature to be used for training a model (e.g., a machine learning model) that predicts a target variable among the plurality of features that constitute the training dataset based on correlation coefficients between each feature and the target variable that constitutes the training dataset together with the sub-feature list generated in operation S130.

FIG. 2 is a flowchart for the execution of operation S150, which subdivides operation S150 into operations S151 to S160. That is, operation S150 may include operations S151 to S160.

It is assumed that the training dataset includes n features. The processor 1010 first initializes a feature index i to 1 in S151. The subsequent operations S152 to S159 are repeatedly executed as many times as the number of the features n. In each execution operation, the processor 1010 determines whether a specific feature fᵢ or a sub-feature in a sub-feature list of the specific feature fᵢ is a suitable feature to be used for training a model predicting a target variable Y. When the feature (or sub-feature) is determined to be suitable, the processor 1010 adds the feature to a list of features to be used for training the model predicting the target variable (a feature list for model training) to update the feature list for model training.

Hereinafter, operations S152 to S160 will be described.

The processor 1010 determines whether a correlation coefficient between the specific feature fᵢ and the target variable Y is greater than a predetermined threshold value (e.g., 0.6) in S152. When the correlation coefficient is greater than the predetermined threshold value, the processor 1010 performs operation S153. Otherwise, the processor 1010 performs operation S158 (i is incremented by 1).

In operation S153, the processor 1010 determines whether the correlation coefficient between the specific feature fᵢ and the target variable Y is greater than the correlation coefficients between all sub-features in the sub-feature list of the specific feature fᵢ and the target variable Y.

When the correlation coefficient between the specific feature fᵢ and the target variable Y is greater than the correlation coefficients between all sub-features in the sub-feature list of the specific feature fᵢ and the target variable Y, the processor 1010 performs operation S154. Otherwise, the processor 1010 performs operation S156.

In operation S154, the processor 1010 determines whether the specific feature fᵢ is included in the feature list for model training. When the specific feature fᵢ is included in the feature list for model training, the processor 1010 increments the feature index i by 1 in S158. Otherwise, the processor 1010 selects the specific feature fᵢ as a feature to be used for training the model predicting the target variable Y and adds the specific feature fᵢ to the feature list for model training in S155 and then increments the feature index i by 1 in S158. In other words, the specific feature fᵢ is added to the feature list if it is not already included in the feature list, and then the feature index is incremented by 1.

Operation S156 is executed when the correlation coefficient between the specific feature fᵢ and the target variable Y is less than or equal to the correlation coefficient between at least one sub-feature in the sub-feature list of the specific feature fᵢ and the target variable Y. In other words, operation S156 is a task of selecting a feature to be included in the feature list for model training among the sub-features of the specific feature fᵢ instead of the specific feature fᵢ. In operation S156, the processor 1010 searches for a sub-feature having the maximum value among the correlation coefficients between the sub-features in the sub-feature list of the specific feature fᵢ and the target variable Y.

When the sub-feature having the maximum value is already included in the feature list for model training, the processor 1010 increments the feature index i by 1 in S158 without updating the feature list. Otherwise, the processor 1010 selects the sub-feature having the maximum value as a feature to be used for training the model predicting the target variable Y and adds the sub-feature to the feature list for model training in S157, and then increments the feature index i by 1 in S158. In other words, the sub-feature having the maximum value (the maximum correlation coefficient) is added to the feature list if it is not already included in the feature list, and then the feature index is incremented by 1.

After operation S158, the processor 1010 determines whether the incremented feature index i exceeds the number n of the features constituting the training data set in S159. If not, the processor 1010 re-executes operation S152 and the subsequent operations.

When the feature index i exceeds the number n of the features, the determination of whether to select a feature has been completed for all features constituting the training data set. The processor 1010 then sets the feature list for model training composed of the features selected so far as a final feature list to be applied to model training. The processor 1010 may sort the features included in the feature list for model training based on the correlation coefficients with the target variable Y and assign importance rankings to each feature. The processor 1010 may transmit the feature list for model training to an external device through a communication device 1020, store the feature list for model training in a memory 1030 or a storage device 1040, display the feature list through an output interface device 1060 and/or output the feature list for model training through the output interface device 1060 in S160.

The method of preprocessing data has been described above with reference to the flowcharts presented in the drawings. While the above method has been shown and described as a series of blocks for the purpose of simplicity, it is to be understood that the present disclosure is not limited to the order of the blocks, and that some blocks may be executed in a different order from that shown and described herein or executed concurrently with other blocks, and various other branches, flow paths, and sequences of blocks that achieve the same or similar results may be implemented. In addition, not all illustrated blocks are necessarily required for implementation of the method described herein.

In the description with reference to FIGS. 1 to 4, each operation may be further divided into a larger number of sub-operations or combined into a smaller number of operations according to examples of implementation of the present disclosure. In addition, some of the operations may not be performed or the order of operations may be changed as needed. In addition, the content of FIGS. 1 to 4 may be performed by the content of FIG. 5.

FIG. 5 is a block diagram illustrating a system for preprocessing data for implementing a method according to embodiments of the present disclosure. The system for preprocessing data may be a computer system as shown in FIG. 5.

Referring to FIG. 5, a system 1000 for preprocessing data may include at least one of a processor 1010, a memory 1030, an input interface device 1050, an output interface device 1060, and a storage device 1040 that communicate through a bus 1070. The system 1000 for preprocessing data may further include a communication device 1020 coupled to a network. The processor 1010 may be a central processing unit (CPU) or a semiconductor device for executing instructions stored in the memory 1030 and/or storage device 1040. The memory 1030 and the storage device 1040 may include various forms of volatile or nonvolatile media. For example, the memory may include a read only memory (ROM) or a random access memory (RAM). In an embodiment of the present disclosure, the memory may be located inside or outside the processor and may be connected to the processor through various known methods. The memory may include various forms of volatile or nonvolatile media, for example, may include a ROM or a RAM. The communication device 1020 may transmit or receive a wired signal or a wireless signal.

Embodiments of the present disclosure may be methods implemented by a computer or non-transitory computer readable medium in which computer executable instructions are stored. According to an embodiment, when executed by a processor 1010, computer readable instructions may perform a method according to at least one aspect of the present disclosure.

The method of preprocessing data according to embodiments of the present disclosure may be implemented in the form of program instructions executable by various computer devices and may be recorded on computer readable media. The computer readable media may be provided with program instructions, data files, data structures, and the like alone or in combination. The program instructions recorded on the computer readable media may be specially designed and constructed for the purposes of the present disclosure or may be well known and available to those skilled in the art of computer software. The computer readable storage media include hardware devices configured to store and execute program instructions. For example, the computer readable storage media include magnetic media such as hard disks, floppy disks, and magnetic tape, optical media such as a compact disc (CD)-ROM and a digital video disk (DVD), magneto-optical media such as floptical disks, a ROM, a RAM, a flash memory, etc. The program instructions include not only machine language code made by a compiler but also high level code that may be used by an interpreter etc., which is executed by a computer.

The processor 1010 is configured to execute the instructions stored in the memory 1030 or the storage device 1040, to thereby generate a feature prediction model based on a training dataset including a plurality of features and a target variable; generate a sub-feature list, which is a list of other features dependent on each feature constituting the training dataset, using the feature prediction model; calculate correlation coefficients between the plurality of features and the target variable based on the training dataset; and select a feature to be used for training a model that predicts the target variable from among the plurality of features based on the correlation coefficients between the plurality of features and the target variable and the sub-feature list.

In one embodiment of the present disclosure, the feature prediction model may be a machine learning model and may be an autoencoder having the same number of input nodes and output nodes as the number of the plurality of features. When the feature prediction model is the autoencoder, the at least one processor may be configured to generate the sub-feature list based on the result of perturbation analysis using the autoencoder, in the process of generating the sub-feature list.

In one embodiment of the present disclosure, the feature prediction model may be a regression model to which Lasso L1 regularization is applied. When the feature prediction model is a regression model to which Lasso L1 regularization is applied, the at least one processor may be configured to generate the sub-feature list based on a perturbation analysis result using the regression model to which Lasso L1 regularization is applied, in the process of generating the sub-feature list.

In addition, the at least one processor may be configured to, in a process of selecting the feature to be used for training the model predicting the target variable, determine whether a correlation coefficient between a specific feature among the plurality of features and the target variable is greater than a predetermined threshold value. Further, when the correlation coefficient between the specific feature and the target variable is greater than the predetermined threshold value, the at least one processor may determine whether the correlation coefficient between the specific feature and the target variable is greater than correlation coefficients between all sub-features in the sub-feature list of the specific feature and the target variable. And when the correlation coefficient between the specific feature and the target variable is greater than the correlation coefficients between all sub-features in the sub-feature list of the specific feature and the target variable, the at least one processor may select the specific feature as the feature to be used for training the model predicting the target variable.

The at least one processor also may be configured to, in a process of selecting the feature to be used for training the model predicting the target variable when the correlation coefficient between the specific feature and the target variable is less than or equal to a correlation coefficient between at least one sub-feature in the sub-feature list of the specific feature and the target variable, select a sub-feature having a maximum value among correlation coefficients between sub-features in the sub-feature list of the specific feature and the target variable as the feature to be used for training the model predicting the target variable.

Further, the at least one processor may be configured to generate a feature list including the selected features when the selecting of the feature to be used for training the model predicting the target variable is performed on all of the plurality of features.

For reference, each operation of the method of preprocessing data according to embodiments of the present disclosure or sub-operations (hereinafter referred to "elements") may be implemented in the form of a software element or a hardware element such as a field programmable gate array (FPGA) and an application specific integrated circuit (ASIC) and may perform a corresponding function. However, the "elements" are not limited to software or hardware. Each of the elements may be configured to be stored in an addressable storage medium and configured to reproduce one or more processors. Examples of the elements may include elements such as software elements, object-oriented software elements, class elements, and task elements, processes, functions, attributes, procedures, subroutines, segments of program code, drivers, firmware, microcode, circuits, data, databases, data structures, tables, arrays, and variables.

Elements and functions provided among the corresponding elements may be combined into fewer elements or may be further divided into additional elements.

It should be understood that the blocks shown in the flowcharts and combinations of the flowcharts can be performed via computer program instructions. These computer program instructions can be installed on processors of programmable data processing equipment, special computers, or general-purpose computers. The instructions executed via the processors of programmable data processing equipment, or the computers can generate a unit that performs functions described in a block (blocks) of the flowchart. In order to implement functions in a particular manner, the computer program instructions can also be stored in a memory that can be used or read by a computer and that can support computers or programmable data processing equipment. Therefore, the instructions stored in the memory that can be used or read by a computer can produce an article of manufacture containing an instruction unit that performs the functions described in the blocks of the flowchart therein. In addition, since the computer program instructions can also be installed on computers or programmable data processing equipment, the computer program instructions can create processes that are executed by a computer through a series of operations that are performed on a computer or other types of programmable data processing equipment so that the instructions are executed by the computer or other programmable data processing equipment and can provide operations for executing the functions described in a block (blocks) of the flowchart.

In addition, each block refers to a part of code, segments or modules that include one or more executable instructions to perform one or more logical functions. It should be noted that the functions described in the blocks may be performed in a different order from the embodiments described above. For example, the functions described in two blocks shown in succession may be performed at the same time or in reverse order in some cases.

According to embodiments of the present disclosure, a sub-feature list, which is a list of sub-features dependent on each feature, is generated using an autoencoder or a Lasso regression model, and features that are independent and have a strong correlation with a target variable are selected based on the correlation coefficient with the target variable and the sub-feature list. This procedure prevents features that are important for predicting the target variable from being omitted.

In addition, according to embodiments of the present disclosure, the number of features to be used for training a model can be reduced to a desired level by setting a criterion of a sub-feature or a threshold value of a correlation coefficient, thereby lowering the complexity of the model and reducing the time required for training. That is, according to embodiments of the present disclosure, additional data is not required to consider the influence of similar features, which allows a machine learning model to be efficiently trained even with limited data.

Effects of the present disclosure are not limited to those described above, and other effects not specifically mentioned herein will be clearly understood by those skilled in the art from the description of the present disclosure below.

## Claims

1. A method of preprocessing data, the method comprising:
using a data preprocessing system to:
receive (S110) a training dataset comprising a plurality of features and a target variable;
generate (S120) a feature prediction model based on the training dataset;
generate (S130), using the feature prediction model, a sub-feature list of other features dependent on each feature constituting the training dataset;
calculate (S140) correlation coefficients between the plurality of features and the target variable based on the training dataset; and
select (S150) a feature to be used for training a model that predicts the target variable from among the plurality of features based on the correlation coefficients and the sub-feature list.

2. The method as claimed in claim 1, wherein the feature prediction model is a machine learning model.

3. The method as claimed in claim 1 or claim 2, wherein the feature prediction model is an autoencoder.

4. The method as claimed in claim 3, wherein generating the sub-feature list comprises generating the sub-feature list based on a result of perturbation analysis using the autoencoder.

5. The method as claimed in claim 1, wherein the feature prediction model is a regression model.

6. The method as claimed in claim 5, wherein the feature prediction model is a regression model to which Lasso L1 regularization is applied.

7. The method as claimed in claim 6, wherein generating the sub-feature list comprises generating the sub-feature list based on a result of perturbation analysis using the regression model to which the Lasso L1 regularization is applied.

8. The method as claimed in any preceding claim, wherein the selecting (S150) of the feature comprises:
determining (S152) whether a correlation coefficient between a specific feature among the plurality of features and the target variable is greater than a predetermined threshold value;
when the correlation coefficient between the specific feature and the target variable is greater than the predetermined threshold value, determining (S153) whether the correlation coefficient between the specific feature and the target variable is greater than correlation coefficients between all sub-features in a sub-feature list of the specific feature and the target variable; and
when the correlation coefficient between the specific feature and the target variable is greater than the correlation coefficients between all sub-features in the sub-feature list of the specific feature and the target variable, selecting (S155) the specific feature as the feature to be used for training the model predicting the target variable.

9. The method as claimed in claim 8, wherein the selecting (S150) of the feature further comprises, when the correlation coefficient between the specific feature and the target variable is less than or equal to a correlation coefficient between at least one sub-feature in the sub-feature list of the specific feature and the target variable, selecting (S157) a sub-feature having a maximum value among correlation coefficients between sub-features in the sub-feature list of the specific feature and the target variable as the feature to be used for training the model predicting the target variable.

10. The method as claimed in any preceding claim, further comprising, generating a feature list comprising the selected features when the selecting (S150) of the feature is performed for all of the plurality of features.

11. A system for preprocessing data, the system comprising:
at least one processor configured to execute instructions stored in at least one memory to thereby cause the system to:
generate (S120) a feature prediction model based on a training dataset comprising a plurality of features and a target variable;
generate (S130), using the feature prediction model, a sub-feature list of other features dependent on each feature constituting the training dataset;
calculate (S140) correlation coefficients between the plurality of features and the target variable based on the training dataset; and
select (S150) a feature to be used for training a model that predicts the target variable, from among the plurality of features based on the correlation coefficients and the sub-feature list.

12. The system as claimed in claim 11, wherein the feature prediction model is a machine learning model.

13. The system as claimed in claim 11 or claim 12, wherein the feature prediction model is an autoencoder.

14. The system as claimed in claim 13, wherein the at least one processor generates the sub-feature list based on a result of perturbation analysis using the autoencoder.

15. The system as claimed in claim 11, wherein the feature prediction model is a regression model.
